**Europäisches Patentamt**

**European Patent Office**

**Office européen des brevets**

(19)

(11) Veröffentlichungsnummer: **0 132 720**
**B1**

## (12) EUROPÄISCHE PATENTSCHRIFT

(45) Veröffentlichungstag der Patentschrift:
**07.01.88**

(21) Anmeldenummer: **84108239.9**

(22) Anmeldetag: **12.07.84**

(51) Int. Cl.⁴: **H 01 L 29/40, H 01 L 21/285,**
**H 01 L 23/48**

(54) **Integrierte Halbleiterschaltung mit einer aus Aluminium oder aus einer Aluminiumlegierung bestehenden äusseren Kontaktleiterbahnebene.**

(30) Priorität: **20.07.83 DE 3326142**

(43) Veröffentlichungstag der Anmeldung:
**13.02.85 Patentblatt 85/7**

(45) Bekanntmachung des Hinweises auf die Patenterteilung:
**07.01.88 Patentblatt 88/1**

(84) Benannte Vertragsstaaten:
**AT CH DE FR GB IT LI NL SE**

(56) Entgegenhaltungen:
**EP - A - 0 000 317**
**EP - A - 0 002 731**
**EP - A - 0 046 914**

**IBM TECHNICAL DISCLOSURE BULLETIN, Band 19, Nr. 9, Februar 1977, Seite 3382, New York, USA; P.L. GARBARINO et al.: "Contact barrier metallurgy for MOSFET gate"**
**CHEMICAL ABSTRACTS, Band 97, 1982, Seite 705, Nr. 173139h, Columbus, Ohio, USA; W.I. LEHRER et al.: "Low-temperature LPCVD deposition of tantalum silicide" & PROC. - ELECTROCHEM. SOC. 1982, 82-87 (VLSI SCI. TECHNOL.), 258-264**

(73) Patentinhaber: **Siemens Aktiengesellschaft Berlin und München, Wittelsbacherplatz 2, D-8000 München 2 (DE)**

(72) Erfinder: **Neppl, Franz, Dr. rer. nat., St. Quirin-Platz 6, D-8000 München 90 (DE)**
Erfinder: **Schwabe, Ulrich, Dr. phil., Plievierpark 14, D-8000 München 83 (DE)**

# Beschreibung

Die Patentanmeldung betrifft eine integrierte Halbleiterschaltung mit einem aus Silizium bestehenden Substrat, in dem und auf dem die die Schaltung bildenden Elemente erzeugt sind, die diffundierte Siliziumbereiche aufweisen, und mit einer aus Aluminium oder aus einer Aluminiumlegierung bestehenden äusseren Kontaktleiterbahnebene, welche unter Verwendung einer Metallsilizidzwischenschicht mit den zu kontaktierenden diffundierten Siliziumbereichen der Schaltung verbunden ist.

Eine Anordnung der eingangs genannten Art, wobei Platinsilizid als Zwischenschicht verwendet wird, ist aus einem Aufsatz von Ting und Wittmer aus Thin Solid Films 96 (1982) Seite 331 bekannt. Die thermische Stabilität liegt bei 400°C.

Eine auf Aluminium oder Aluminium-Legierungen wie Aluminium-Silizium oder Aluminium-Silizium-Titan basierende Metallisierung für integrierte Halbleiterschaltungen ist ebenfalls aus dem genannten Aufsatz von Ting und Wittmer bekannt. Die thermische Stabilität liegt bei 550°C. Das Metallisierungssystem besitzt folgende Nachteile:

1. Die Ausbildung kleiner Kontakte zu flachen hochdotierten Diffusionsgebieten im Siliziumsubstrat ist sehr problematisch, da wegen des sogenannten «spiking» und/oder epitaktischen p-Silizium-Wachstums in den Kontakten (Degradierung von n+-Kontakten) Substratkurzschlussgefahr besteht.

2. Temperaturstabile Schottky-Dioden mit niedriger Barriere $\varnothing_B$ auf n-Silizium herzustellen, wie sie zum Beispiel für «clamped transistors» benötigt werden, die zum Beispiel in Schottky-TTL-Schaltkreisen oder in kombinierten CMOS/Schottky-TTL-Schaltkreisen verwendet werden, ist sehr schwierig, da das Aluminium im allgemeinen an die Grenzflächen diffundiert und $\varnothing_B$ erhöht.

Diese Nachteile können weitgehend dadurch behoben werden, dass zusätzlich zur Kontaktierungsschicht weitere Schichten als Diffusionsbarrieren verwendet werden.

So ist beispielsweise aus dem bereits zitierten Aufsatz von Ting und Wittmer in «Thin Solid Films» 96 (1982) auf Seite 338 ein Dreischichtsystem, bestehend aus Aluminium, Titan und Platinsilizid zu entnehmen, wobei sich das Platinsilizid nur im Kontaktloch befindet.

Aus der US-A-4 201 999 (Howard) ist weiterhin bekannt, für die Realisierung von Schottky-Dioden mit niedriger Barriere auf n-Silizium ein Dreischichten-Metallisierungssystem bestehend aus Tantal, Tantal-Aluminium und Aluminium zu verwenden.

Der Nachteil dieser Metallisierung liegt darin, dass Tantal im Kontakt mit Silizium bereits bei verhältnismässig niedrigen Temperaturen zur Silizidbildung tendiert, wodurch Substratkurzschlüsse verursacht werden können.

Der Aufbau dieser bekannten Schichtsysteme erfordert zusätzliche Prozessschritte, welche erhebliche Mehrkosten verursachen und die Fehlerquoten bei der Herstellung der integrierten Schaltungen erhöhen können.

Die Aufgabe, die der Erfindung zugrundeliegt, besteht deshalb in der Angabe eines auf Aluminium basierenden Metallisierungssystems, welches nicht nur leichter realisierbar und einfacher aufgebaut ist, sondern auch die Zuverlässigkeit und Belastbarkeit von elektrischen Leiterbahnen und Kontaken zu flachen Diffusionsgebieten bei VLSI-Systemen (= very large scale integration) weiter erhöht.

Diese Aufgabe wird durch eine integrierte Halbleiterschaltung der eingangs genannten Art gelöst, welche erfindungsgemäss dadurch gekennzeichnet ist, dass die Zwischenschicht aus Tantaldisilizid besteht, wobei der Tantalgehalt der Verbindung grösser ist als es der Tantaldisilizid-Stöchiometrie entspricht, wodurch die Diffusion von Aluminium und Silizium im Tantaldisilizid verhindert wird.

Dabei liegt es im Rahmen des Erfindungsgedankens, dass die Zwischenschicht durch gleichzeitiges Aufdampfen der beiden Elemente oder durch Hochfrequenzzerstäuben unter Verwendung eines aus Tantalsilizid bestehenden Targets erzeugt ist. Bei der Art dieser Herstellung scheidet sich aus Tantalsilizid bestehenden Targets erzeugt ist. Bei der Art dieser Herstellung scheidet sich das Tantalsilizid in amorpher Form ab.

Gemäss einem anderen Ausführungsbeispiel nach der Lehre der Erfindung wird die Zwischenschicht durch Abscheidung aus der Gasphase, beispielsweise durch thermische Zersetzung eines aus Tantalhalogenid und Silan bestehenden Gasgemisches gebildet.

Die Verwendung einer Tantalsilizidschicht zur Verhinderung einer Ausdiffusion von Aluminium zwischen einer Kontaktleiterbahnebene und einer Polysiliziumgatestruktur ist zwar aus dem IBM Technical Disclosure Bulletin, Vol. 19, No. 9, Februar 1977, Seite 3382, bekannt, doch wird diese hier durch Aufdampfen einer Tantalschicht und anschliessende Silizidbildung bei 400–800°C aus der Polysilizium-Gatestruktur erzeugt. Eine Diffusionsbarriere aus Tantaldisilizid mit erhöhtem Tantalgehalt ist nicht offenbart.

Weiterhin ist aus der EP-A-0 000 317 bekannt, dass mit einer Zunahme des Tantalgehaltes die Leitfähigkeit einer Tantalsilizidschicht zunimmt, wobei insbesondere auf die Verbindung $Ta_5Si_3$ hingewiesen wird. Die Verbindung $Ta_5Si_3$ ist eine stöchiometrische Verbindung und bekannterweise bei hohen Temperaturen nicht stabil. Auch hier entsteht im Endeffekt die stabile Tantaldisilizidverbindung, die keinen Tantalüberschuss und damit die Diffusionsbarrierenbildung nicht aufweist. Die aus der EP-A-0 000 317 bekannten Schichten dienen ausschliesslich der Erhöhung der Leitfähigkeit von Polysiliziumverbindungen bzw. als direkte Elektrodenschichten auf diffundierten Siliziumbereichen und weisen vorzugsweise einen Siliziumüberschuss auf.

Weitere Ausgestaltungen der Erfindung ergeben sich aus den Unteransprüchen.

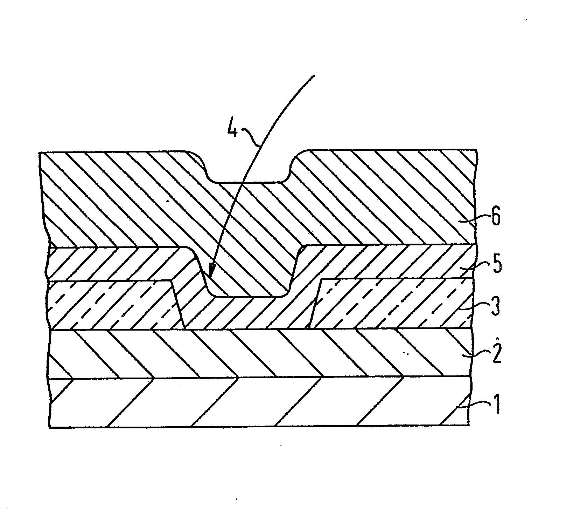

Im folgenden wird anhand der in der Zeichnung befindlichen Figur der Schichtaufbau des Kontaktes im Schnittbild noch näher erläutert.

Dabei ist mit dem Bezugszeichen 1 das den n+- bzw. p+-dotierten Bereich 2 enthaltende Substrat und mit 3 die das Kontaktloch enthaltende $SiO_2$-Schicht bezeichnet. Nach bekannten Verfahren der Halbleitertechnologie (Co-Sputtern, Co-Dampfen oder CVD-Verfahen (= chemical vapor deposition)) wird eine Tantaldisilizidschicht 5 in einer Schichtdicke von 100 bis 500 nm aufgebracht, wobei die Abscheidung so gesteuert wird, dass mehr Tantal niedergeschlagen wird, als es der Tantaldisilizid-Stöchiometrie entspricht. Dies geschieht beispielsweise durch Verwendung eines Tantalsilizidtargets aus einer Legierung mit Tantalüberschuss. Auf die Tantaldisilizidschicht 5 wird eine zum Beispiel dotierte Aluminiumschicht 6 in einer Schichtdicke von 500–2000 nm aufgedampft und diese Doppelschicht (5, 6) dann gemeinsam strukturiert (in der Figur nicht dargestellt).

Es ist aber auch möglich, durch ein selektives CVD-Verfahren das Tantalsilizid nur im Kontaktloch (siehe Pfeil 4) abzuscheiden.

Die Aluminiumschicht 6 dient der Minimierung des Leitbahnwiderstandes und ermöglicht die problemlose Kontaktierung. Die Tantaldisilizidschicht 5 wirkt gleichzeitig als Diffusionsbarriere und als Kontaktiermaterial. Dies ist möglich, da einerseits mit Tantaldisilizid ohmsche Kontakte aus n+- und p+-Silizium hegestellt werden können und die Schottky-Barriere zu n-Silizium mit 0,59 eV ausreichend niedrig ist, andererseits Tantaldisilizid mit einem höheren Tantalgehalt als der Tantaldisilizid-Stöchiometrie entspricht die Aluminium-Diffusion bei Temperschritten verhindert.

Folgende Vorteile ergeben sich durch die erfindungsgemässe Metallisierung:

1. Es werden nur zwei, statt üblicherweise drei Schichten verwendet, wodurch die Herstellung (zum Beispiel Ätzung und Abscheidung) wesentlich vereinfacht wird.

2. Es wird eine geringe Reaktionstiefe in (100)-Silizium erzielt, da bereits Silizid statt dem reinen Metall abgeschieden wird.

3. Es findet keine Aluminiumdiffusion in die Kontakte statt.

4. Es entsteht kein p-Silizium-Epitaxie-Wachstum in den Kontakten.

5. Es kann bei der Abscheidung von Aluminium auf den Siliziumzusatz verzichtet werden.

6. Die Abscheidung beider Schichten mit dem gleichen Verfahren, zum Beispiel mit dem CVD-Verfahren, ist möglich.

7. Tantaldisilizid besitzt eine hohe Strombelastbarkeit, so dass bei ganzflächiger Silizidbeschichtung eine Sicherheitsreserve bei Aluminium-Unterbrechungen vorhanden ist.

## Patentansprüche

1. Integrierte Halbleiterschaltung mit einem aus Silizium bestehenden Substrat (1), in dem und auf dem die die Schaltung bildenden Elemente erzeugt sind, die diffundierte Siliziumbereiche (2) aufweisen, und mit einer aus Aluminium oder aus einer Aluminiumlegierung bestehenden äusseren Kontaktleiterbahnebene (6), welche unter Verwendung einer Metallsilizidzwischenschicht (5) mit den zu kontaktierenden diffundierten Siliziumbereichen (2) der Schaltung verbunden ist, dadurch gekennzeichnet, dass die Zwischenschicht (5) aus Tantaldisilizid besteht, wobei der Tantalgehalt der Verbindung grösser ist als es der Tantaldisilizid-Stöchiometrie entspricht, wodurch die Diffusion von Aluminium und Silizium im Tantaldisilizid verhindert wird.

2. Integrierte Halbleiterschaltung nach Anspruch 1, dadurch gekennzeichnet, dass die Zwischenschicht (5) durch gleichzeitiges Aufdampfen der beiden Elemente oder durch Hochfrequenzzerstäuben unter Verwendung eines Tantalsilizidtargets erzeugt ist.

3. Integrierte Halbleiterschaltung nach Anspruch 1, dadurch gekennzeichnet, dass die Zwischenschicht (5) durch Abscheidung aus der Gasphase, beispielsweise durch thermische Zersetzung eines aus Tantalhalogenid und Silan bestehenden Gasgemisches gebildet ist.

4. Integrierte Halbleiterschaltung nach Anspruch 3, dadurch gekennzeichnet, dass die Zwischenschicht selektiv nur im Kontaktloch abgeschieden ist.

5. Integrierte Halbleiterschaltung nach einem der Ansprüche 1 bis 4, dadurch gekennzeichnet, dass die Kontaktleiterbahnebene (6) aus einer Aluminiumlegierung der Systeme Aluminium-Kupfer, Aluminium-Silizium, Aluminium-Kupfer-Silizium oder Aluminium-Silizium-Titan besteht.

6. Integrierte Halbleiterschaltung nach einem der Ansprüche 1 bis 5, gekennzeichnet durch eine Schichtdicke der Zwischenschicht (5) im Bereich von 100 bis 500 nm.

7. Integrierte Halbleiterschaltung nach einem der Ansprüche 1 bis 3, 5 und 6, dadurch gekennzeichnet, dass die Zwischenschicht (5) mit der sie bedeckenden Kontaktleiterbahnebene (6) strukturiert ist, so dass die Metallisierung aus einer Doppelschicht (5, 6) besteht.

## Claims

1. An integrated semiconductor circuit comprising a substrate (1) consisting of silicon and in and on which are produced the elements which form the circuit and which have diffused silicon zones (2), and an external contact conductor path plane (6) which consists of aluminium or an aluminium alloy and which is connected to the diffused silicon zones (2) of the circuit which are to be contacted, using a metal silicide intermediate layer (5), characterised in that the intermediate layer (5) consists of tantalum disilicide, in which the tantalum content of the compound is greater than that corresponding to stoichiometric tantalum disilicide, as a result of which the diffusion of aluminium and silicon into the tantalum disilicide is prevented.

2. An integrated semiconductor circuit as claimed in Claim 1, characterised in that the intermediate layer (5) is produced by simultaneous vapour deposition of the two elements, or by high-frequency atomisation using a tantalum silicide target.

3. An integrated semiconductor circuit as claimed in Claim 1, characterised in that the intermediate layer (5) is formed by deposition from the gas phase, for example by thermal decomposition of a gas mixture consisting of tantalum halide and silane.

4. An integrated semiconductor circuit as claimed in Claim 3, characterised in that the intermediate layer is selectively deposited only in the contact hole.

5. An integrated semiconductor circuit as claimed in one of Claims 1 to 4, characterised in that the contact conductor path plane (6) consists of an aluminium alloy of the systems: aluminium-copper, aluminium-silicon, aluminium-copper-silicon, or aluminium-silicon-titanium.

6. An integrated semiconductor circuit as claimed in one of Claims 1 to 5, characterised by a thickness of the intermediate layer (5) in the range of 100 to 500 nm.

7. An integrated semiconductor circuit as claimed in one of Claims 1 to 3, 5 and 6, characterised in that the intermediate layer (5) is structured with the contact conductor path plane (6) covering it, so that the metallisation consists of a double layer (5, 6).

## Revendications

1. Circuit à semi-conducteurs intégré, comprenant un substrat (1) constitué par du silicium et dans lequel ou sur lequel sont réalisés les éléments constitutifs du circuit qui présentent des zones de diffusion de silicium (2), ainsi qu'un plan extérieur (6) de pistes conductrices de contact en aluminium ou en un alliage d'aluminium, ledit plan extérieur étant relié aux zones de diffusion de silicium (2) du circuit à contacter, avec mise en œuvre d'une couche intermédiaire (5) en siliciure métallique, caractérisé par le fait que la couche intermédiaire (5) est constituée par du disiliciure de tantale, la teneur en tantale du composé étant supérieure à celle qui correspond au silicium de tantale stœchiométrique, grâce à quoi on empêche la diffusion de l'aluminium et du silicium dans le di-siliciure de tantale.

2. Circuit à semi-conducteurs intégré selon la revendication 1, caractérisé par le fait que la couche intermédiaire (5) est produite par évaporation simultanée des deux éléments ou par pulvérisation haute fréquence, avec mise en œuvre d'une cible de siliciure de tantale.

3. Circuit à semi-conducteurs intégré selon la revendication 1, caractérisé par le fait que la couche intermédiaire (5) est produite par le dépôt à partir de la phase gazeuse, par exemple par décomposition thermique d'un mélange gazeux constitué par l'halogénure de tantale et le silane.

4. Circuit à semi-conducteurs intégré selon la revendication 3, caractérisé par le fait que la couche intermédiaire est déposée de façon sélective uniquement dans le trou de contact.

5. Circuit à semi-conducteurs intégré selon l'une des revendications 1 à 4, caractérisé par le fait que le plan de pistes conductrices de contact (6) est constitué par un alliage d'aluminium des systèmes aluminium-cuivre, aluminium-silicium, aluminium-cuivre-silicium ou aluminium-silicium-titane.

6. Circuit à semi-conducteurs intégré selon l'une des revendications 1 à 5, caractérisé par une épaisseur de couche de la couche intermédiaire (5) qui se situe dans la zone de 100 à 500 nm.

7. Circuit à semi-conducteurs intégré selon l'une des revendications 1 à 3, 5 et 6, caractérisé par le fait que la couche intermédiaire (5) est structurée avec le plan de pistes conductrices de contact (6) qui la recouvre, en sorte que la métallisation est constituée par une couche double (5, 6).